# EUROPÄISCHE PATENTANMELDUNG

(11) **EP 0 658 771 A2**
(43) Veröffentlichungstag der Anmeldung: **21.06.1995**
(21) Anmeldenummer: 94117963.2
(22) Anmeldetag: 15.11.1994
(51) Int. Cl.: G01R 31/28

(54) **Anzeigeeinrichtung für elektrische Steuergeräte**

(30) Priorität: 14.12.1993 DE 4342586
(71) Anmelder: ROBERT BOSCH GMBH, 70442 Stuttgart (DE)
(72) Erfinder: Schneider, Thomas, Dipl.-Ing., D-71706 Markgroeningen (DE); Grieser-Schmitz, Stefan, D-55129 Mainz (DE); Walther, Michael, Dr.-Ing., D-71636 Ludwigsburg (DE)

(57) **Zusammenfassung**

Es wird eine Anzeigeeinrichtung für elektrische Steuergeräte angegeben, bei der Anzeigemittel, beispielsweise eine Leuchtdiode mit wenigstens zwei Widerständen zwischen Versorgungsspannung und Masse gelegt sind und die Ansteuerleitung vom Steuergerät ausgeht und zwischen die beiden Widerstände angeschlossen ist. Das Steuergerät beeinflußt dabei das Potential auf der Ansteuerleitung derart, daß nur im gewünschten Fall, also bei erkanntem Fehler, eine Anzeige erfolgt, jedoch bei einem Kurzschluß zwischen der Ansteuerleitung und der Versorgungsspannung sowie bei einer Unterbrechung der Ansteuerleitung ebenfalls eine Anzeige erfolgt.

## Beschreibung

### Stand der Technik

Die Erfindung geht aus von einer Anzeigeeinrichtung für elektrische Steuergeräte nach der Gattung des Hauptanspruchs.

Elektrische Steuergeräte, die beispielsweise Zur Regelung einer Brennkraftmaschine vorgesehen sind, lösen beim Auftreten von Fehlern eine Anzeige aus. Dazu werden die Anzeigemittel über eine Ansteuerleitung betätigt. Insbesondere im Zusammenhang mit der Überwachung von sicherheitsrelevanten Einrichtungen in Kraftfahrzeugen, beispielsweise bei ABS-Systemem ist es erforderlich, auch die Ansteuerleitung zu überwachen, so daß es möglich ist, eine Unterbrechung der Ansteuerleitung sowie einen Kurzschluß zwischen der Ansteuerleitung und der Versorgungsspannung zu erkennen. Eine solche Einrichtung ist aus der noch nicht veröffentlichten deutschen Gebrauchsmusteranmeldung G 93 131 291 bekannt. Diese bekannte Einrichtung ist jedoch relativ aufwendig aufgebaut.

### Vorteile der Erfindung

Die erfindungsgemäße Anzeigeeinrichtung für elektrische Steuergeräte mit den Merkmalen des Hauptanspruchs hat demgegenüber den Vorteil, daß sie sehr einfach aufgebaut ist und dennoch zuverlässig sowohl eine Unterbrechung der Ansteuerleitung als auch einen Kurzschluß zwischen der Ansteuerleitung und einer auf Versorgungsspannung liegenden Leitung anzeigt.

Ermöglicht wird dies, indem die Anzeigemittel über einen Spannungsteiler zwischen Versorgungsspannung und Masse gelegt sind und die Ansteuerleitung zwischen den beiden Widerständen des Spannungsteilers angeschlossen ist, wobei das vom Steuergerät beeinflußte Potential auf der Ansteuerleitung eine Höhe aufweist, die sicherstellt, daß das Anzeigemittel sowohl bei einem vom Steuergerät erkannten Fehler, der angezeigt werden soll, als auch bei einer Unterbrechung der Ansteuerleitung bzw. einem Kurzschluß zwischen der Ansteuerleitung und einer auf Versorgungsspannung liegenden Leitung, ausgelöst wird.

Weitere Vorteile der Erfindung werden durch die in den Unteransprüchen angegebenen Maßnahmen erzielt. Eine vorteilhafte Ausgestaltung der Erfindung besteht dabei darin, als Anzeigemittel eine Leuchtdiode, die in Durchlaßrichtung in Reihe mit den Widerständen liegt, zu verwenden. Besonders vorteilhaft ist, zusätzlich in diese Reihenschaltung noch eine Zenerdiode in Sperrichtung zu legen, es wird damit sichergestellt, daß die Schaltungsanordnung auch bei einem Masseversatz zuverlässig funktioniert.

### Zeichnung

Zwei Ausführungsbeispiele der Erfindung sind in den beiden Figuren der Zeichnung dargestellt und werden in der nachfolgenden Beschreibung näher erläutert.

### Beschreibung der Ausführungsbeispiele

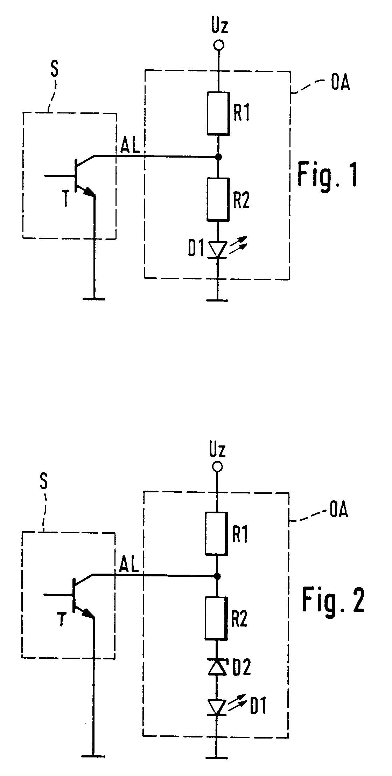

In Figur 1 ist ein erstes Ausführungsbeispiel dargestellt, bei dem eine Reihenschaltung, die aus den Widerständen R1, R2 und der Diode D1 besteht, zwischen der Versorgungsspannung Uz und Masse liegt. Die Diode D1 ist dabei eine Leuchtdiode, die in Durchlaßrichtung geschaltet ist. Die beiden Widerstände R1 und R2 sowie die Leuchtdiode D1 bilden eine optische Anzeigeeinrichtung OA.

Zwischen den Widerständen R1 und R2 ist die Ansteuerleitung AL angeschlossen, die auf der anderen Seite mit dem Steuergerät S verbunden ist. Dabei ist die Beschaltung üblicherweise so, daß die Ansteuerleitung mit dem Kollektor eines Transistors T verbunden ist, während der Emitter des Transistors T auf Masse liegt.

Vom Steuergerät wird das Basispotential des Transistors T derart angesteuert, daß die Leuchtdiode D1 bei einem vom Steuergerät S erkannten Fehler aufleuchtet.

Da die Ansteuerleitung AL zwischen den beiden Widerständen R1 und R2 angeschlossen ist, während die Leuchtdiode auf der anderen Seite des Widerstandes R2 liegt und die andere Seite des Widerstandes R1 auf Versorgungsspannung liegt, wird bei einer Unterbrechung der Ansteuerleitung die Leuchtdiode D1 ebenfalls aufleuchten, da dann ein Strom durch die Widerstände R1 und R2 sowie die Leuchtdiode D1 nach Masse fließt.

Bei einem Kurzschluß zwischen der Ansteuerleitung AL und der Versorgungsspannung Uz fließt der Strom direkt durch den Widerstand R2 und die Leuchtdiode D1, diese leuchtet wiederum auf. Bei Kurzschluß von T1 bleibt der Kollektor auf Uz.

Liegt keine Unterbrechung zwischen der Ansteuerleitung AL und der optischen Anzeige OA und kein Kurzschluß zwischen der Ansteuerleitung AL und der Versorgungsspannung Uz vor, leuchtet die Diode D1 bei durchgeschaltetem Transistor nicht auf, da in diesem Fall das Potential am Verbindungspunkt zwischen den beiden Widerständen R1 und R2 so weit erniedrigt wird, daß der Spannungsabfall über der Leuchtdiode D1 nicht mehr ausreicht, diese zum Leuchten zu bringen.

Soll dagegen bei funktionierende Anzeigeeinrichtung ein vom Steuergerät erkannter unzulässiger Betriebszustand bzw. ein erkannter Fehler angezeigt werden, erfolgt dies, indem das Steuergerät mittels des Transistors T das Potential der Ansteuerleitung AL und damit auch das Potential zwischen den beiden Widerständen R1 und R2 so beeinflußt, daß ein Strom durch den Widerstand R1, den Widerstand R2 und die Diode D1 fließt und diese aufleuchtet.

In Figur 2 ist ein erweitertes Ausführungsbeispiel dargestellt, das prinzipiell gleich funktioniert wie das Ausführungsbeispiel nach Figur 1, wobei gleiche Bauteile auch dieselben Bezeichnungen tragen. Zusätzlich ist bei diesem Ausführungsbeispiel nach eine Zenerdiode D2 in der optischen Anzeige OA enthalten. Dabei ist diese Zenerdiode D2 in Sperrichtung zwischen den Widerstand R2 und die Leuchtdiode D1 geschaltet. Diese Zenerdiode D2 bewirkt, daß die optische Anzeige OA auch bei einem Masse-Potentialversatz zwischen der optischen Anzeigeeinrichtung und dem Steuergerät S funktioniert.

Für das Potential der Ansteuerleitung AL, das von Steuergerät S durch Schalten des Transistors T beeinflußt wird, gilt, daß es so hoch sein muß, daß bei vom Steuergerät erkannten Fehlern und gewünschter Anzeige über D1 ein Strom durch R1, R2 die Zenerdiode D2 und die Leuchtdiode D1 fließen kann. Soll keine Anzeige erfolgen, wird der Transistor T wieder durchgeschaltet und die Leuchtdiode D1 leuchtet nicht.

Bei einer Unterbrechung der Ansteuerleitung AL liegt die volle Spannung UZ an der Serienschaltung der beiden Widerstände R1, R2 sowie der Dioden D2 und D1. Die Diode D1 leuchtet in diesem Fall ebenso auf, wie bei einem Kurzschluß zwischen der Ansteuerleitung AL und der Versorgungsspannung Uz.

Die beiden Ausführungsbeispiele weisen lediglich Widerstände und Dioden auf, es sind also keine aktiven Bauelemente für die Anzeige erforderlich. Dies gilt insbesondere für die optische Anzeige OA.

Anstelle einer Leuchtdiode D1 kann auch eine andere optische Anzeige, beispielsweise eine Glühlampe oder eine Glimmlampe eingesetzt werden. Soll eine andere als eine optische Anzeige oder ein geeignetes sonstiges Anzeigemittel erfolgen, kann die Diode D1 auch durch ein akustisches Bauteil ersetzt werden.

## Patentansprüche

1. Anzeigeeinrichtung für elektrische Steuergeräte mit Anzeigemitteln, die zwischen Versorgungsspannung und Masse geschaltet sind und vom Steuergerät über eine Ansteuerleitung ansteuerbar sind, wobei eine Überwachung der Ansteuerleitung vorgesehen ist, die die Anzeige bei einer Unterbrechung der Ansteuerleitung oder einem Kurzschluß zwischen der Ansteuerleitung und einem Versorgungsspannungsanschluß aktiviert, dadurch gekennzeichnet daß die Anzeigemittel eine Reihenschaltung aus wenigstens zwei Widerständen und einem Anzeigemittel umfassen, wobei das Anzeigemittel zwischen der Versorgungsspannung und Masse liegt und die Ansteuerleitung zwischen den beiden Widerständen angeschlossen ist.

2. Anzeigeeinrichtungnach Anspruch 1, dadurch gekennzeichnet, daß das Anzeigemittel eine in Durchlaßrichtung geschaltete Leuchtdiode oder eine Lampe ist.

3. Anzeigeeinrichtung nach Anspruch 1 oder 2, dadurch gekennzeichnet, daß zusätzliche eine Zenerdiode zwischen den Anzeigemitteln und dem mit dem Anzeigemittel verbundenen Widerstand liegt, wobei die Zenerdiode in Sperrichtung gepolt ist.

4. Anzeigeeinrichtung nach einem der vorhergehenden Ansprüche dadurch gekennzeichnet, daß die Widerstände und die Leuchtdiode oder die Lampe, gegebenenfalls einschließlich der Zenerdiode zu einer optischen Anzeigeeinrichtung zusammengefaßt sind.

5. Anzeigeeinrichtung nach einem der vorhergehenden Ansprüche, dadurch gekennzeichnet, daß die Ansteuerleitung mit einem Transistor in Verbindung steht, der Bestandteil des Steuergerätes ist und von diesem angesteuert wird.

6. Anzeigeeinrichtung nach Anspruch 5, dadurch gekennzeichnet, daß das Potential der Ansteuerleitung durch den Transistor so beeinflußt wird, daß es hoch ist, wenn eine Anzeige bei intakter Ansteuerleitung erfolgen soll.

7. Anzeigeeinrichtung nach Anspruch 5 oder 6, dadurch gekennzeichnet, daß die Ansteuerleitung mit dem Kollektor des Transistors verbunden ist und der Emitter des Transistors auf Masse liegt und das Basispotential des Transistors vom Steuergerät beeinlfußbar ist.
